# EUROPEAN PATENT APPLICATION

(11) **EP 2 330 616 A2**
(43) Date of publication of application: **08.06.2011**
(21) Application number: 10176486.8
(22) Date of filing: 03.11.2003
(51) Int. Cl.: H01L 21/324, H01L 21/00, H01L 21/762

(54) **A method of rapidly thermally annealing multilayer wafers with an edge**

(30) Priority: 05.11.2002 FR 0213810; 13.01.2003 FR 0300286
(62) Divisional of application: 03772490.3
(71) Applicant: S.O.I. Tec Silicon on Insulator Technologies, 38190 Bernin (FR)
(72) Inventor: Neyret, Eric, 38360 Sassenage (FR); Malleville, Christophe, 38660 La Terrasse (FR)
(74) Representative: Collin, Jérôme

(57) **Abstract**

The invention provides a method of thermally treating a multilayer wafer (10) with an edge, the wafer being made of materials selected from semiconductive materials and the method being characterized in that during annealing heating is adapted locally and selectively at the edge to take account of the local difference in heat absorption by the edge.

## Description

The present invention relates to a method of applying heat treatment to a multilayer wafer with an edge, the wafer being made of materials selected from semiconductive materials.

The term "multilayer wafer with an edge" is mused herein to mean a wafer of semiconductive material which presents the following two characteristics:
- the wafer is a "multilayer" wafer, i.e. it is made up of an assembly of at least two layers; and
- the multilayer wafer has an "edge", i.e. it has a peripheral edge (it being understood that the kind of wafers to which the invention relates are generally circular in shape) presenting a step in thickness typically because at least one upper layer of the wafer is note present in the peripheral edge, with only the lower layer(s) being present therein.

And a preferred (but not limiting) application of the invention relates to wafers of the silicon on insulator (SOI) type comprising an assembly of layers as follows:
- a working top layer of silicon;
- an insulating intermediate layer constituted by an oxide; and
- a bottom support layer.

Methods that are well suited to obtaining such wafers are transfer methods in which zones of weakness are created. Under such circumstances, the working layer of silicon is obtained from a silicon substrate in which the zone of weakness has been created.

An example of such methods are methods of the Smartcut® type.

When the wafer of SOI is detached from its substrate in the zone of weakness, only the central portion (which, seen from above, constitutes much the larger portion) of the silicon layer is actually detached from the substrate.

In the peripheral region of the wafer, detachment does not actually occur, such that the resulting SOI wafers present an "edge" in the form of a downward step.

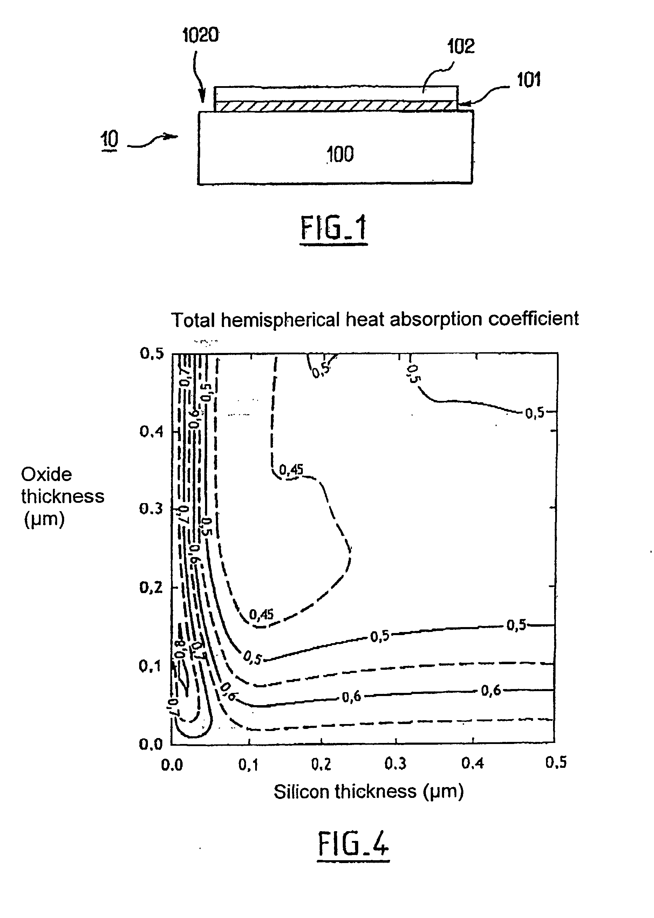

This is shown in highly diagrammatic manner in Figure 1, in which there can be seen a wafer 10 of SOI after detachment, the wafer comprising a support layer 100, an insulating layer 101, and a working layer 102 of silicon, the layers 101 and 102 defining a peripheral edge 1000 that is a few millimeters wide.

It is emphasized that SOI constitutes only one of the applications of the invention, and it is used merely by way of illustration in the present text. The invention is applicable to any type of multilayer wafer with an edge that is made of materials selected from semiconductive materials.

Such wafers are generally subjected to heat treatments, e.g. for the purposes of modifying the composition of one or more layers of the wafer, of stabilizing a bonding interface between two layers, of curing structural defects, and/or of improving the surface state of the wafer, ....

Such heat treatments (or annealing operation) can be implemented in a wide variety of manners.

Thus, some annealing operations are performed in temperature ranges that are referred to as "low" for applications of the invention.

In the context of the present invention, "low" temperatures are defined by convention as being less than a value of about 500°C to 600°C.

This definition is given solely for the purposes of the present description, and it should be understood that it does not necessarily correspond to a definition that is universally accepted in the field of the invention.

Annealing may also be undertaken at "high" temperatures, i.e. at values greater than about 500°C-600°C.

One particular mode of high temperature annealing is known as rapid thermal processing (RTP).

In RTP mode, the processing temperature is generally very high (typically about 950°C or higher), and the annealing time is kept down to a duration of the order of a few minutes.

It is thus known to subject SOI type wafers to rapid thermal annealing (RTA) where the temperature reaches values of about 1100°C to 1250°C, the total duration of annealing being of the order of a few tens of seconds only.

The effect of such annealing is to smooth the surface of a wafer.

It is common to find that the roughness specifications for such wafers must not exceed 5 angstroms (Å) in root mean square (rms) value.

Wafers (in particular. SOI wafers) can also be subjected to other types of RTP annealing, for example annealing of the rapid thermal oxidation (RTO) type. Such annealing, which is performed under an oxidizing atmosphere, serves to oxidize the surface of the wafer.

The wafers to which the invention applies can thus be subjected to various types annealing.

The Applicant has observed that drawbacks are associated with annealing operations performed on such wafers.

More precisely, the Applicant has observed annealing operations of the RTP type (including RTA, RTO, ...) generate defects known as "slip lines" in wafers.

Such slip lines are generated in particular by temperature non-uniformities in three dimensions within an annealing furnace (i.e. temperature is not strictly identical at all points), and they develop under the effect of the above-mentioned very high levels of thermal stress.

It has also been observed that these slip lines are generally initiated in the peripheral region of the wafer.

With multilayer wafers with an edge, this phenomenon of slip lines at the periphery of the wafer is particularly severe.

RTP type annealing thus tends to generate slip lines, and this drawback is more particularly severe in wafers concerned by the invention (multilayer wafers with an edge and made of materials selected from semiconductive materials).

Such heat treatments subject the wafer to very high levels of thermal stress because of the very rapid temperature rises they induce.

It should be observed that this major drawback is more severe with annealing performed by radiating heat from one or more heat sources. A typical illustration is RTP annealing using infrared lamps emitting heat radiation, with the wafer being placed facing the lamps.

This drawback is less severe when annealing is performed by thermal conduction (as happens in an annealing furnace filled with a heat-conducting gas surrounding the wafer).

For annealing that does not involve RTP mode (i.e. annealing performed at low temperature), this drawback is less severe.

However another drawback remains: even with low-temperature annealing, wafer deformation can still be observed.

Such deformation is typically associated with wafers bending or twisting to some extent, as can be observed, for example by variation in the warp of the wafer.

Warp represents the maximum deformation of the wafer relative to an "ideal" wafer, which should be absolutely flat.

Such warp can also be observed with annealing performed in RTP mode.

It thus appears that annealing performed on multilayer wafers with an edge and made of materials selected from semiconductive materials is associated with drawbacks.

The object of the invention is to obviate these drawbacks,

To achieve this object, in a first aspect, the invention provides a method of heat treating a multilayer wafer with an edge, the wafer being made of materials selected from semiconductive materials, the method being characterized in that during annealing, heating is adapted locally and selectively at the edge in order to take account of the local difference in heat absorption by the ring.

Such a method relates specifically to the problem of multilayer wafers that have an edge. This problem which has been shown up by the Applicant is associated with differences of heat absorption coefficient at the edge of such a multilayer wafer.

In this respect, it is mentioned that certain documents suggest solutions for adapting the heating of a wafer locally, e.g. by selectively powering the infrared lamps placed facing different regions of the wafer.

However, those documents do not seek in any way to solve the particular problem mentioned above. The teaching of those documents is in general limited to treating simple single-layer wafers without edges, where the specific problem on which the invention is based does not arise.

It is also specified that other documents suggest solutions for adapting heating at the periphery of a wafer, by using a thermal continuity ring.

However the teaching of those documents is limited to setting up thermal continuity in order to avoid edge effects which do not correspond to the specific problem mentioned above.

Examples of documents relating to the above-mentioned prior art techniques include the following in particular:
- WO 01/69656 (disclosing a ring which acts in conventional manner to absorb heat and to return it to the wafer it surrounds - in particular without in any way adapting the ring or its disposition in order to address the specific problem on which the invention is based);
- US 2001/036219 and US 5 937 142 which propose adapting heating locally for a wafer which is not a multilayer wafer;
- US 6 235 543 and US 6 184 498 which propose systems enabling the conditions under which defects appear in a wafer to be characterized, that wafer likewise not being a multilayer wafer, and for the purpose of subsequently adapting the heating as a function of those conditions under which defects appear; and
- EP 399 662, EP 1 197 989, US 4 958 061, and US 6 051 512 which propose thermal continuity rings and ways of implementing them.

None of those documents deals with the problem on which the present invention is based (preventing the appearance of defects such as slip lines generated due to a difference of heat-absorption coefficient at the edge of a multilayer wafer).

Furthermore, none of those documents even mentions the problem which is associated specifically with multilayer wafers.

Returning to the method of the present invention, preferred but non-limiting features of the method are as follows:
- the thermal processing is a rapid thermal processing;
- the thermal processing is a smoothing annealing;
- the thermal processing is an oxidation annealing;
- in order to adapt heating, account is taken of the respective heat absorption coefficients of the central region and of the edge of the wafer;
- said heat absorption coefficients are determined on the basis of the natures of the materials constituting the layers of the wafer, and on the basis of the respective thicknesses of said layers;
- the wafer is an SOI wafer and, compared with a given heating reference for a wafer that does not present an edge, heating is reduced selectively at the edge;
- in order to adapt heating, the power supply to infrared lamps situated facing the edge is controlled selectively;
- during annealing, the wafer is placed within a thermal continuity structure;
- in order to adapt the heating, the dimensions of the thermal continuity structure are adapted selectively;
- the wafer is an SOI wafer and, compared with annealing a wafer that does not present an edge, the thickness of the thermal continuity structure is reduced;
- in order to adapt the heating, the spacing between the wafer and the thermal continuity structure is adapted selectively;
- the wafer is an SOI wafer and, compared with annealing a wafer that does not present an edge, the spacing between the wafer and the thermal continuity structure is increased;
- in order to adapt the heating, the shape of the thermal continuity structure is adapted selectively;
- the wafer is an SOI wafer and, compared with annealing a wafer that does not present an edge, a thermal continuity structure is adopted whose edges facing the wafer slope downwards;
- the wafer is selected in such a manner as to present in its central region and on its edge thermal absorption coefficients that are substantially equivalent; and
- the substantial equivalence of the coefficients in the central region and on the edge of the wafer is obtained by taking into consideration the natures of the materials constituting the layers of the wafer in the central region and in its edge, and the respective thicknesses of said layers.

In a second aspect, the invention also proposes the use of a method in accordance with any one of the above features in thermally processing an SOI wafer.

Finally, in a third aspect, the invention provides:
- a thermal continuity structure for use in a method in accordance with any one of' the above features, characterized in that the dimensions of the thermal continuity structure are adapted to contribute to establishing an edge temperature on the wafer that is substantially equivalent to the temperature of the remainder of the surface of the wafer, in spite of the differences of heat absorption by the edge; and
- a thermal continuity structure for use in a method in accordance with any one of the above features, characterized in that the shape of the thermal continuity structure is adapted to contribute to establishing an edge temperature on the wafer that is substantially equivalent to the temperature of the remainder of the surface of the wafer, in spite of the differences of heat absorption by the edge. The section of the structure may, in particular, present an edge that slopes downwards towards the inside.

Other aspects, objects, and advantages of the invention appear better on reading the following description of preferred embodiments of the invention made with reference to the accompanying drawings, in which, in addition to above-described Figure 1:
- Figure 2 is a diagrammatic view of an installation enabling annealing to be performed in accordance with the invention;
- Figures 3a to 3c are diagrams showing thermal continuity structures implemented respectively in conventional thermal annealing (3a), and in annealing operations of the invention (3b and 3c); and
- Figure 4 (taken from the work "Handbook of semiconductor manufacturing technology, p. 224, 2000" by Timans et al.) is a chart showing the values of the heat absorption factor of multilayer wafers as a function of the respective thicknesses of the layers of the wafer.

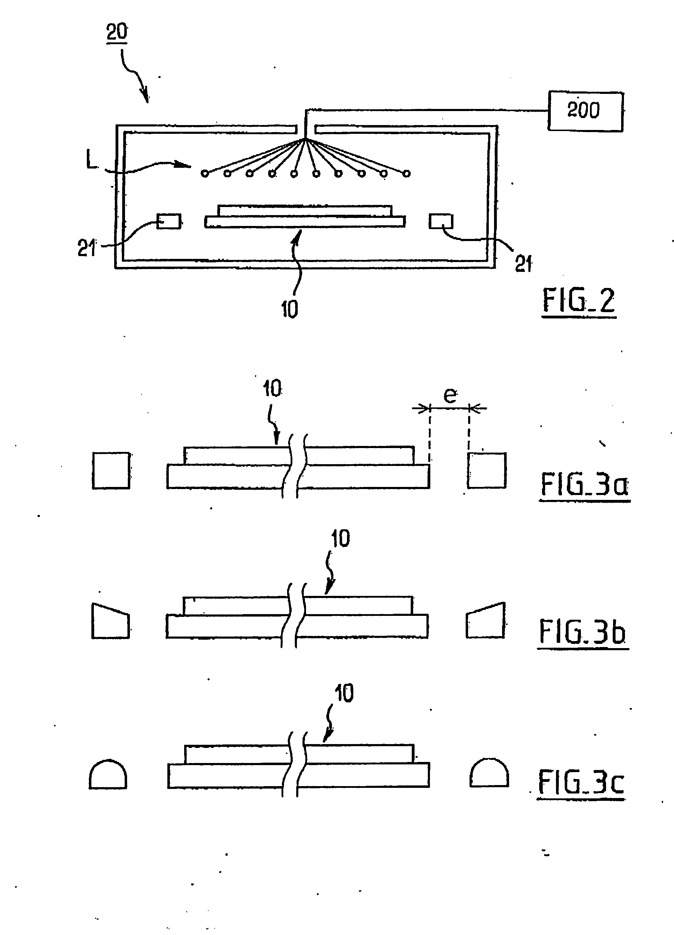

With reference initially to Figure 2, an annealing installation 20 is shown for performing annealing on a wafer 10 with an edge.

This installation is suitable for performing RTP type annealing, e.g. annealing for smoothing purposes.

This type of installation has been elected to illustrate the invention since the drawbacks generated by such annealing (slip lines, and other drawbacks) are particularly severe.

A particularly advantageous application of the invention thus lies with RTP type annealing, e.g. RTO annealing, or RTA type finishing annealing for smoothing the surface of the wafer.

Nevertheless, it is specified that the invention is not limited to this type of annealing, but applies to all of the modes of annealing mentioned in the introduction to this text.

The installation 20 can thus be used to perform high-temperature annealing which does not constitute an RTP mode, or even low-temperature annealing.

In addition, in RTP type annealing (which this installation is also suitable for performing), some of the drawbacks mentioned in the introduction of this text (in particular warp) can appear during the rise in temperature which is performed before the dwell at high temperature.

In this figure, as in Figures 3a to 3c, the wafer 10 is shown with only two visible layers. Nevertheless, the wafer may be any type of wafer, as mentioned above.

In a preferred application of the invention, the wafer 10 is an SOI wafer.

It could equally be any multilayer wafer with an edge, the wafer being made of materials selected from semiconductive materials.

In particular, it can be a wafer of silicon germanium on insulator (SGOI) or a wafer having a fine layer of SiGe on a supporting substrate (which may be of any kind, for example of Si), wafers of this category generally being associated with the same thermal stresses at the edge as are SOI wafers, which are used by way of example in the text below.

In this respect, it is also specified that the description made below with reference to an SOI wafer is, in particular, directly transposable to wafers of the above-mentioned categories.

The wafer may also be a multilayer wafer of the SOQ type (silicon on quartz).

In any event, the wafers to which the invention applies are multilayer wafers including an edge, for which the invention provides an advantageous solution concerning any differences in heat absorption by the edge.

The wafer 10 is heated by means of infrared lamps L which are disposed facing the wafer.

A unit 200 serves to control electrical power supply to the lamps.

As explained below, the unit 200 is suitable for controlling the supply of power to the various lamps selectively and individually so as to control the power emitted individually by each of the lamps.

As a result, it is possible to control individually the power emitted by each lamp.

For further description about this technique, reference can be made for example to document WO 01/69656 which shows annealing apparatus (for rapid thermal annealing) in which the various lamps are controlled individually.

There can also be seen in Figure 2 (which shows the apparatus in section) a thermal continuity structure 21 which surrounds the wafer 10, and which is spaced apart therefrom.

The structure 21 is thus in the form of a closed ring which is placed concentrically about the wafer 10.

This structure which is commonly referred to as an "edge ring" serves to establish a certain amount of continuity in heat absorption beyond the edges of the wafer 10.

In the absence of such a structure, interfering edge effects are observed at the periphery of the wafer.

An example of such an edge ring is to be found in document WO 01/69656 (edge ring 17).

Some of the drawbacks which the invention seeks to solve originate in the peripheral edge region of the wafer (this applies in particular to the generation of slip lines).

However it is emphasized that the mere fact of placing a thermal continuity structure around the wafer does not, of itself, solve these drawbacks.

In the prior art, the function of edge rings is limited to establishing a degree of thermal continuity in absorption beyond the borders of the wafer.

For this purpose, edge rings are generally of a "basic" section that is rectangular in shape.

As explained below, in an embodiment of the invention, improvements are proposed for such edge rings in order to perform a specific function of local and selective adaptation of heating at the peripheral edge of the wafer placed at the center of the edge ring.

In addition, for known edge rings, the spacing between the edge ring and the wafer it surrounds is generally dimensioned solely for the purpose of allowing the wafer to expand during the thermal processing.

In the invention, this spacing can be adapted selectively as a function of the thermal absorption coefficient at the edge of the wafer for the purpose of returning a greater or smaller amount of heat to the wafer (returning more heat when the spacing between the edge ring and the wafer is smaller).

When it is desired to increase heating at the edge of the wafer by using this local absorption coefficient, then the spacing is reduced. On the contrary, if the absorption coefficient at the edge of the wafer requires heating at the edge to be decreased, then the spacing is increased.

In order to take account of the peripheral edge of the wafer, the lamps L facing said ring are powered selectively so as to adapt the heat power they radiate to the intrinsic heat absorption characteristics of said edge.

Thus, with an SOI wafer:
- the central region having an SOI multilayer structure presents a thermal absorption factor lying in the range 0.4 to 0.8, depending on the thickness of the SOI;
- whereas the peripheral edge represents a different thermal absorption factor. For example this factor may be about 0.7 when the support is made of silicon.

It will thus be understood that the central region and the edge region neither absorb nor reflect infrared heat radiation in the same manner.

These differences give rise to localized temperature differences on the surfaces of these two regions, thus encouraging the appearance of slip lines.

By adapting heating at the edge selectively and locally to take account of this difference in thermal absorption by the edge, the establishment of temperatures that are substantially equivalent over the surface of both of these regions of the wafer is encouraged, thereby preventing the apparition of slip lines.

The apparatus 20 is filled with a gaseous mixture, for example a mixture of hydrogen and argon, or it could be filled with pure argon.

The wafer is heated for the most part by the direct infrared radiation coming from the lamps L, however a smaller part of its heating comes from thermal conduction via the gaseous mixture.

This facilitates local control over the temperature of the wafer by selectively controlling the various lamps that face said wafer.

In order to define the selective commands applied to the various lamps, account is taken mainly of the respective heat absorption coefficients of the central region and of the edge of the wafer.

These heat absorption coefficients are essentially determined on the basis of the natures of the materials constituting the layers of these two regions in the wafer and the respective thickness of said layers.

Figure 4 thus represents the simple case of a wafer comprising a layer of silicon on a layer of oxide on a silicon substrate.

In this figure, it can be seen that the heat absorption coefficient varies as a function of the relative thicknesses of these two layers.

Naturally, it is possible to establish equivalent charts for any type of multilayer wafer, as a function of the natures of the various layers.

For an SOI wafer which is a composite structure (i.e. built up as a stack of different layers), it is generally found that the central region corresponding to the SOI itself absorbs less heat than does the peripheral edge of silicon.

In such case it is appropriate to heat the central region of the wafer more than the edge, as compared with the heating that would be applied to a non-composite structure.

For a multilayer wafer with an edge and made out of material selected from semiconductive materials, the power supply to the lamps of the apparatus is adapted selectively to heat the central region to a greater or lesser extent than the peripheral region as a function of the heat absorption coefficients of these two regions:
- if the edge has a heat absorption coefficient that is lower than that of the central region of the wafer, then heating is stronger at the edge than in the central region;
- if the converse situation applies, then the heating is stronger in the central region.

Determining the heat absorption coefficients of the layers of the multilayer wafer thus makes it possible to adapt the heating applied to the various regions of the multilayer wafer.

It should be understood that this adaptation of the heating can be performed, as explained above, by selectively adapting the power fed to the various infrared lamps.

However, heating can be adapted by other means, either as an alternative or in combination with such selective power supply to the heater means.

In any event, the heat absorption coefficients can be determined in particular by using charts of the type shown in Figure 4, which, for a multilayer wafer, plot the heat absorption coefficient as a function of the nature of the materials of the wafers and as a function of their thicknesses.

Thus, with selective power feed to the infrared lamps, first means are made available for making the amount of heat actually absorbed by the various regions of the wafer more uniform.

These first means correspond to a first implementation of the invention, which does not make use of the thermal continuity structure.

In this implementation, use of the structure is optional: it can be omitted.

However, as explained below, such a thermal continuity structure can be adapted and implemented astutely to constitute second means for making the amount of heat actually absorbed by the various regions of the wafer more uniform.

Such adaptation/implementation of the thermal continuity structure constitutes a second implementation of the invention.

This second implementation can be optionally be combined with the first implementation.

Returning to the thermal continuity structure 21 shown in Figure 2, this structure can be placed around the wafer and at the same height as the wafer, as shown in Figure 2.

Depending on the constraints associated with the annealing furnace used, this thermal continuity structure may alternatively be placed around the wafer but below it, so as to enable the wafer to be moved into its annealing position by following a horizontal path.
Figures 3a to 3c show three types of thermal continuity structure.
Figure 3a shows a conventional configuration for such a structure, where it has a rectangular cross-section of constant thickness.

In the second embodiment of the invention, it is possible to use such a thermal continuity structure by selectively adapting its dimensions so as to adapt temperature locally at the edge of the wafer, taking account of the local difference in heat absorption by said edge.

A thicker structure 21 (i.e. of section as shown in Figures 3a to 3c of greater width) tends to increase temperature at the edge of the wafer.

It is thus possible to vary the thickness of the thermal continuity structure as a function of the respective heat absorption coefficients of the central region and of the edge of the wafer.

Returning to the case of SOI in which the edge presents a heat absorption coefficient greater than that of the central region, the thickness of the thermal continuity structure is smaller than it would be for annealing a wafer that does not have an edge.

It is also possible to adapt selectively the spacing e between the wafer and the thermal continuity structure 21.

Increasing this spacing contributes to reducing the temperature at the edge of the wafer.

For the above-mentioned SOI case, the spacing e should be increased compared with annealing a wafer that does not have an edge.

It is also possible to adapt the shape of the thermal continuity structure selectively so as to adapt heating at the edge locally and selectively.

Figures 3b and 3c thus show specific shapes for the section of the structure 21:
- this section may be shaped to slope downwards towards the inside as in Figure 3b; or
- this section may have a rounded top, likewise with a surface that slopes downwards the inside as shown in Figure 3c.

In particular, adopting a thermal continuity structure 21 whose section presents a downward slope facing the wafer, contributes to reducing temperature at the edge of said wafer.

This solution is thus well adapted to the above-mentioned case of an SOI wafer.

It is emphasized that the above-mentioned dispositions relating to the size of the structure 21, to the magnitude of the spacing e, and to the shape of the structure 21 can be adopted in combination with one another.

These dispositions can also be taken in combination with selective power supply to the lamps L (combining both implementations of the invention as mentioned above).

In a third implementation of the invention, it is also possible to use charts of the kind shown in Figure 4 for selecting a multilayer wafer with an edge and that presents substantially equivalent heat absorption coefficients in its central region and in its edge.

This can be achieved by taking into consideration the natures of the materials constituting the layers of the wafer in these two regions, and the respective thicknesses of these layers.

In particular, if a wafer having layers made of given materials is to processed, it is possible to adapt the thicknesses of the layers so as to achieve substantially equivalent heat absorption coefficients in the central region and in the edge of the wafer.

In this third implementation, it is also possible to add selectively layers or layer portions in such a manner as to modify the heat absorption coefficient of the wafer (for the entire wafer, or locally).

This can be done to obtain wafers having thermal characteristics that are modified.

In particular, this makes it possible to increase the ranges of thicknesses that are possible for the various layers of the wafer, for the purpose of obtaining a desired heat absorption coefficient for the wafer.

Adding a layer having selected thermal characteristics can lead to greater tolerance in the thicknesses that can be selected for other layers of the wafer - still for the purpose of obtaining a desired heat absorption coefficient for the wafer.

Such an increase in the ranges of possible thicknesses can be characterized for the wafer in question by plotting a chart similar to that of Figure 4 (which corresponds to an SOI wafer).

This third implementation of the invention can also be combined with one or both of the first two implementations described above.

Selecting thicknesses for the layers of the wafer and/or inserting special layers can be implemented in combination with all of the above-mentioned dispositions (selectively powering the lamps L, adapting the characteristics of a thermal continuity structure 21), enabling the differences between the respective heat absorption coefficients of the central region and of the edge of the wafer to be minimized.

## Claims

1. A method of heat treating a multilayer wafer (10) having a central region and a peripheral region each having a surface, the peripheral region being of a thickness lower than the thickness of the central region so that the central region and the peripheral region absorb or reflect heat radiation in a different manner, the wafer being made of materials selected from semiconductive materials, the method being **characterized by** a selection step before annealing, said selection step comprising selecting a multilayer wafer having a structure with a central region and a peripheral region of equal heat absorption coefficients.

2. The method of claim 1, wherein selection of the multilayer wafer comprises adapting the nature of the materials constituting the layers of the wafer in both the central and peripheral regions, and adapting the respective thicknesses of said layers.

3. The method of claim 1, wherein selection of the multilayer wafer comprises selecting a multilayer wafer with layers in both the central and peripheral regions of given materials, and adapting the respective thicknesses of said layers.

4. The method of any of the preceding claims, wherein selection of the multilayer wafer comprises selectively adding layers or layer portions for locally modify the heat absorption coefficient of the multilayer wafer.

5. The method of any of the preceding claims, wherein during annealing, heating is adapted locally and selectively at the peripheral region in order to compensate for the local differences in heat absorption.

6. The method of any of the preceding claims, wherein during annealing, heating is adapted by selectively powering infrared lamps (L) facing the central and peripheral regions.

7. The method of any of the preceding claims, wherein during annealing, the wafer is placed within a thermal continuity structure (21).

8. The method of claim 7, wherein during annealing, heating is adapted by adapting the characteristics of the thermal continuity structure (21).

9. The method of any of claims 7 to 8, wherein during annealing, heating is adapted by selectively adapting the dimensions of the thermal continuity structure (21).

10. The method of any of claims 7 to 9, wherein during annealing, heating is adapted by selectively adapting the spacing (e) between the wafer and the thermal continuity structure (21).

11. The method of any of claims 7 to 10, wherein during annealing, heating is adapted by selectively adapting the shape of the thermal continuity structure (21).

12. A method according to any of claims 1 to 11, wherein the thermal processing is a rapid thermal processing.

13. A method according to any of claims 1 to 11, wherein the thermal processing is a smoothing annealing.

14. A method according to any of claims 1 to 11, wherein the thermal processing is an oxidation annealing.

15. The use of a method according to any of the preceding claims in thermally processing an SOI wafer.
